# EUROPÄISCHE PATENTSCHRIFT

(11) **EP 1 155 446 B1**
(45) Veröffentlichungstag und Bekanntmachung des Hinweises auf die Patenterteilung: **27.09.2006**
(21) Anmeldenummer: 00912377.9
(22) Anmeldetag: 15.02.2000
(51) Int. Cl.: H01L 21/8242, H01L 27/108

(54) **VERFAHREN ZUM HERSTELLEN EINER DRAM-ZELLE MIT EINEM GRABENKONDENSATOR**
METHOD FOR PRODUCING A DRAM CELL WITH A TRENCH CAPACITOR
PROCEDE DE PRODUCTION DE CELLULES DRAM AVEC UN CONDENSATEUR DE TRANCHEE

(30) Priorität: 19.02.1999 DE 19907174
(43) Veröffentlichungstag der Anmeldung: 21.11.2001
(73) Patentinhaber: Infineon Technologies AG, 81669 München (DE)
(72) Erfinder: TIHANYI, Jenoe, D-85551 Kirchheim (DE)
(74) Vertreter: Barth, Stephan Manuel
(86) Internationale Anmeldenummer: PCT/DE2000/000435
(87) Internationale Veröffentlichungsnummer: WO 2000/049654

(56) Entgegenhaltungen:
- JP-A- 7 161 936
- US-A- 5 181 089
- US-A- 5 477 071
- PATENT ABSTRACTS OF JAPAN vol. 14, no. 394 (E-969), 24. August 1990 (1990-08-24) & JP 02 146766 A (NEC CORP), 5. Juni 1990 (1990-06-05)
- PATENT ABSTRACTS OF JAPAN vol. 14, no. 239 (E-930), 21. Mai 1990 (1990-05-21) & JP 02 065271 A (TOSHIBA CORP), 5. März 1990 (1990-03-05)
- PATENT ABSTRACTS OF JAPAN vol. 1996, no. 8, 30. August 1996 (1996-08-30) & JP 08 088330 A (TOSHIBA CORP), 2. April 1996 (1996-04-02)

## Beschreibung

Die vorliegende Erfindung betrifft ein Verfahren zum Herstellen einer DRAM-Zelle mit einem Grabenkondensator.

Aus der US-A-5,181,089 sind eine Halbleiterspeichervorrichtung und ein entsprechendes Herstellungsverfahren bekannt, wobei in einem Substrat Grabenkondensatoren hergestellt werden und in einer darüberliegenden Zone entsprechende Auswahltransistoren.

Die JP 02 146766 A offenbart eine Speicherzelle mit einem Grabenkondensator, über dem ein MOS-Auswahltransistor mittels einer Halbleiter-Laminierungsstruktur angeordnet ist.

Bei DRAM-Speichern wird auf den gepulsten Betrieb von SRAM-Speichern zurückgegriffen. Die in der Speicherzelle stets vorhandenen Kapazitäten, z.B. die Gatekapazität, werden benutzt, um ihren Zustand eine gewisse Zeit zu erhalten. Dieses Prinzip erlaubt eine deutliche Vereinfachung der Speicherzelle, so daß Leistungsverbrauch und Flächenbedarf sinken: die Packungsdichte des Speichers steigt. Um die Packungsdichte noch weiter zu steigern, ist man bestrebt, den Flächenbedarf von DRAM-Zellen weiter zu senken. Dabei ist es das Ziel, die Speicherkapazität groß und die Streukapazitäten der Bit- und Wortleitungen möglichst klein zu halten. Gleichzeitig sollen die Herstellverfahren für einen DRAM-Chip möglichst einfach sein.

In US-A-4,797,373 wird eine DRAM-Speicherzelle und ein Herstellungsverfahren für eine DRAM-Speicherzelle in Trench-Technik beschrieben. Bei der DRAM-Zelle nach diesem Stand der Technik umfaßt die Zelle einen Feldeffekt-Transistor und einen Speicherkondensator, wobei sowohl der Transistor als auch der Kondensator in einem Graben in einem Substrat gefertigt sind. Die Source des Transistors, der Kanal und der Drain sowie eine Kondensatorfläche werden im wesentlichen vertikal in den Seitenwänden des Bulk-Substrats angeordnet, und das Gate und die andere Kondensatorfläche werden in zwei Bereichen eines Materials angeordnet, das in den Graben eingesetzt ist und von dem Bulk durch eine Isolatorschicht isoliert wird. Mit anderen Worten, der Speicherkondensator und der Auswahltransistor werden praktisch unter der Kreuzungsfläche der Bit- und Wortleitungen übereinander angeordnet.

Das Verfahren zum Herstellen einer DRAM-Speicherzelle mit einer Speicherkapazität und einem Auswahltransistor nach dem obigen Stand der Technik umfaßt im wesentlichen die folgenden Schritte:
Ätzen eines Grabens in einem Substrat eines ersten Leitfähigkeitstyps;
Beschichten der Seitenflächen des Grabens mit einer ersten dünnen Isolatorschicht;
Füllen des ausgekleideten Grabens bis zu einer vorgegebenen Höhe mit leitfähigen Material eines zweiten Leitfähigkeitstyps;
Entfernen der freiliegenden Isolatorschicht einschließlich von Randbereichen der Isolatorschicht zwischen dem leitfähigen Material und dem Substrat;
Abscheiden eines leitfähigen Materials in den Randbereichen;
Diffundieren von Dotierstoff aus dem leitfähigen Material durch die Randbereiche in das den Graben umgebende Substrat, so daß sich in Höhe der Randbereiche im Substrat schwach dotierte Gebiete von dem zweiten Leitfähigkeitstyp ergeben, die als Source des Auswahltransistors dienen;
Bilden eines Drain-Bereichs in dem dem oberen Teil des Grabens benachbarten Substrat;
Bilden einer Gate-Isolatorschicht in dem oberen Teil des Grabens; und
Füllen des restlichen Grabens mit einem als Gate dienenden leitfähigen Material.

Das Substrat weist dabei eine hoch dotierte untere Zone und eine weniger hoch dotierte obere Zone auf, wobei die Source des Auswahltransistors sich in der schwächer dotierten oberen Zone befindet.

Sechs wesentliche Schritte betreffen dabei die Herstellung der Speicherkapazität und des Gates des Auswahltransistors, die restlichen drei Schritte betreffen ausschließlich den Auswahltransistor. Bei den Verfahrensschritten besteht eine wesentliche Schwierigkeit darin, das Ätzen an den vorgegebenen Randbereichen kontrolliert durchzuführen, so daß die Dimensionen der vorgegebenen Randbereiche reproduzierbar sind.

Aufgabe der vorliegenden Erfindung ist es, ein Herstellungsverfahren für eine DRAM-Zelle anzugeben, das einfach durchzuführen ist, eine hohe Ausbeute hat, eine hohe Packungsdichte der DRAM-Zellen zuläßt und die Leiterbahnkapazitäten reduziert.

Diese Aufgabe wird gelöst durch ein Verfahren zum Herstellen einer DRAM-Zelle nach Anspruch 1. Bevorzugte Weiterbildungen der Erfindung sind Gegenstand der Unteransprüche.

Der Erfindung liegt die Idee zugrunde, die DRAM-Zelle mit einem Verfahren herzustellen, das ähnliche Schritte wie das SOI-Verfahren aufweist, nämlich bei dem eine einkristalline Siliziumschicht auf einem Träger angeordnet wird. Während der Träger beim SOI-Verfahren ein Isolator ist (SOI = Silicon on Insulator), wird bei dem erfindungsgemäßen "Quasi-SOI"-Verfahren die einkristalline Siliziumschicht als zweite Zone auf einer weiteren Siliziumschicht erzeugt, die eine erste Zone darstellt. In der ersten Zone wird die Speicherkapazität der DRAM-Zelle erzeugt, und in einer Siliziumsäule in der zweiten, oberen Zone wird der Auswahltransistor erzeugt. Das erfindungsgemäße Verfahren zum Herstellen einer DRAM- Speicherzelle weist damit die Schritte auf:
Erzeugen eines ersten Grabens in einer ersten Zone von einem ersten Leitfähigkeitstyp, Beschichten der Oberfläche des ersten Grabens mit einer ersten Isolatorschicht und Auffüllen des ersten Grabens mit einem leitfähigen Material von einem zweiten Leitfähigkeitstyp, wobei die erste Zone und das leitfähige Material in dem ersten Graben hoch dotiert sind;
Anordnen einer zweiten Zone von dem ersten Leitfähigkeitstyp auf der ersten Zone, so daß der erste Graben abgedeckt ist, Erzeugen eines Bereiches von dem zweiten Leitfähigkeitstyp in der zweiten Zone durch Diffusion von Dotierstoff aus dem leitfähigen Material in dem ersten Graben;
Ätzen von Nachbarbereichen neben dem ersten Graben, so daß Halbleitermaterial ausgehend von der Oberfläche der zweiten Zone bis in die erste Zone hinein entfernt wird;
Auffüllen der Nachbarbereiche mit einem Isolatormaterial, so daß ein Isolator bereich zwischen benachbarten ersten Gräben erzeugt wird;
Erzeugen von Bitleitungen aus leitfähigem Material von dem zweiten Leitfähigkeitstyp und von Drain-Zonen für Auswahltransistoren an der Oberfläche der zweiten Zone;
Erzeugen des Auswahltransistorgates in einem zweiten Graben in der zweiten Zone oberhalb des ersten Grabens in der ersten Zone; und
Erzeugen von Wortleitungen aus leitfähigem Material auf der freiliegenden Oberfläche der zweiten Zone.

Vorzugsweise umfaßt das Anordnen der zweiten Zone auf der ersten Zone die Schritte "Direct Wafer Bonding" der zweiten Zone mit der ersten Zone und Dünnen der zweiten Zone auf eine vorgegebene Dicke. Damit wird es möglich, in einem einfachen Schritt die zwei unterschiedlich dotierten Zonen aufeinander anzuordnen. Das Dünnen kann durch Ätzen oder durch Schleifen und anschließendes Polieren erfolgen.

Bei einer bevorzugten Weiterbildung des Verfahrens erfolgt das Beschichten der Oberfläche des ersten Grabens mit einer Isolatorschicht jeweils durch Oxidieren.

Insbesondere können die Nachbarbereiche des ersten Grabens, in denen Halbleitermaterial abgetragen wurde, durch ein Dickoxyd aufgefüllt werden. Dies ist in einem einfachen Arbeitsschritt möglich.

Ein Vorteil der Erfindung liegt darin, daß weniger , d.h. beim Ausführungsbeispiel nur noch fünf Masken gegenüber sechs beim vergleichbaren Stand der Technik bei der Herstellung benötigt werden. Ein weiterer Vorteil besteht darin, daß mit dem erfindungsgemäßen Verfahren die parasitären Kapazitäten der DRAM-Speicherzelle kleiner bleiben als bei den Verfahren nach dem Stand der Technik.

Weitere Merkmale und Vorteile der Erfindung ergeben sich aus der folgenden Beschreibung eines zeichnerisch dargestellten Ausführungsbeispiels.

Es zeigen:
- Fig. 1: einen Querschnitt durch eine DRAM-Zelle, die nach dem erfindungsgemäßen Verfahren hergestellt wurde; und
- Fig. 2: das elektrische Ersatzschaltbild der DRAM-Zelle nach Fig. 1.

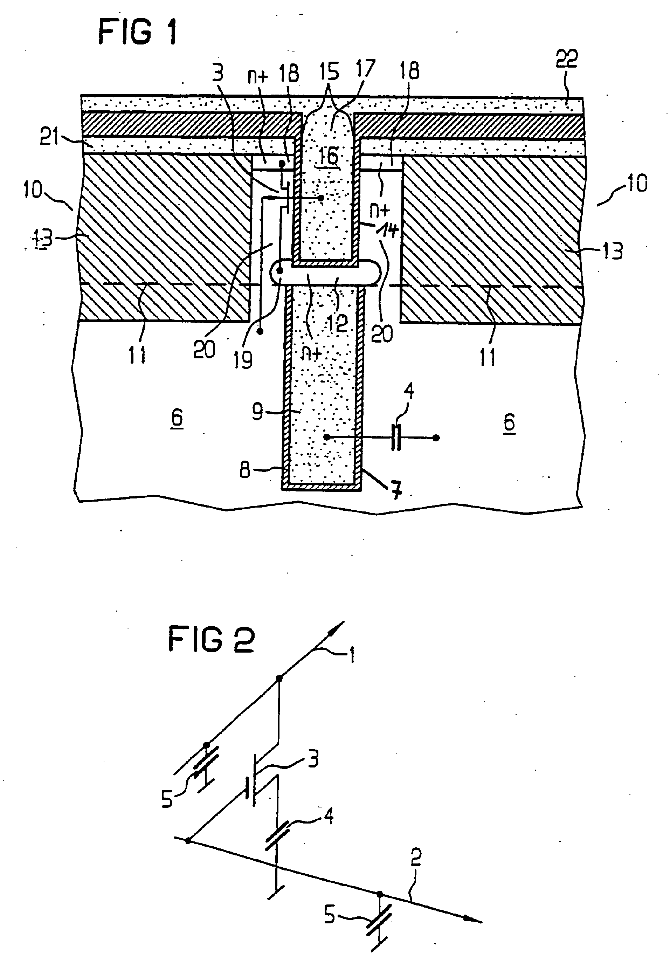

In Fig. 1 ist eine Ausführungsform einer DRAM-Zelle, die mit dem erfindungsgemäßen Verfahren hergestellt wurde, im Querschnitt dargestellt.

Zur Erläuterung der schaltungstechnischen Anforderungen an eine DRAM-Zelle sollen jedoch zunächst die wesentlichen Anschlüsse der DRAM-Zelle anhand ihres elektrischen Ersatzschaltbildes in Fig. 2 gezeigt werden.

Eine DRAM-Zelle befindet sich an einem Schnittpunkt einer Bitleitung 1 und einer Wortleitung 2. Die Bitleitung ist in der Regel mit dem Drain eines Auswahltransistors 3 verbunden, der über sein Gate von der Wortleitung 2 angesteuert wird. Für den Fall, daß der Transistor über die Wortleitung 2 ausgewählt wird, geht er in seinen leitenden Zustand über und verbindet einen Speicherkondensator 4 mit der Bitleitung 1 für das Beschreiben bzw. das Auslesen.

Entlang der Bitleitungen 1 und der Wortleitungen 2 bilden sich parasitäre Kapazitäten 5, die unvermeidbar sind. Da sie jedoch das Schaltverhalten der DRAM-Zelle negativ beeinflussen, versucht man, sie möglichst gering zu halten. Ihre Größe hängt u.a. von dem Herstellungsverfahren der DRAM-Zelle ab.

Wie bereits oben erwähnt ist man bestrebt, den Flächenbedarf einer einzelnen DRAM-Zelle möglichst klein zu halten. Aus diesem Grund werden die heutigen DRAM-Zellen mit einem Stapelkondensator als Speicherkapazität oder mit einem Grabenkondensator als Speicherkapazität ausgeführt. Die vorliegende Erfindung bezieht sich auf DRAM-Zellen mit Grabenkondensatoren. Das erfindungsgemäße Verfahren zum Herstellen einer DRAM-Zelle mit Grabenkondensator wird anhand von Fig. 1 erläutert.

Während zur Herstellung der DRAM-Zelle beim Stand der Technik ein einziger Graben in einem Halbleitersubstrat erzeugt wird, in den nacheinander zunächst eine Elektrode des Speicherkondensators und danach das Gate des Auswahltransistors eingebaut werden, werden bei dem erfindungsgemäßen Verfahren der Speicherkondensator und der Auswahltransistor unabhängig voneinander gefertigt. Dadurch werden Verfahrensschritte eingespart, die beim Stand der Technik zum Trennen von Kondensator und Gate in demselben Graben durchgeführt werden müssen.

Das erfindungsgemäße Verfahren zum Herstellen einer DRAM-Speicherzelle mit Grabenkondensator ist ein "Quasi SOI"- Verfahren (SOI = Silicon on Insulator). Bei dem Quasi-SOI- Verfahren wird einkristallines Silizium - statt auf einem Isolator - auf einem weiteren Halbleiter aufgewachsen. Diese Technik zeichnet sich dadurch aus, daß sie wesentlich einfacher durchzuführen ist als Verfahren nach dem Stand der Technik.

Bei dem Verfahren wird in einem ersten Schritt eine erste Elektrode des Speicherkondensators 4 als Grabenelektrode hergestellt. Der Grabenkondensator 4 ist schematisch zur Erläuterung in Fig. 1 eingezeichnet. Zur Herstellung des Grabenkondensators 4 wird wie dem Fachmann allgemein bekannt ein erster Graben 7 in einer ersten Zone 6 erzeugt. Die erste Zone 6 ist von einem ersten Leitfähigkeitstyp, d.h. in dem gezeigten Ausführungsbeispiel vom p-Typ. Anschließend wird die Oberfläche des ersten Grabens 7 mit einer ersten Isolatorschicht 8 beschichtet. Bei dieser Isolatorschicht 8 kann es sich um eine Oxidschicht des umgebenden Halbleiters o.ä. handeln. Schließlich wird der erste Graben 7 mit einem leitfähigen Material 9 von einem zweiten Leitfähigkeitstyp, d.h. in dem gezeigten Ausführungsbeispiel vom n-Typ aufgefüllt. In der gezeigten Ausführungsform handelt es sich bei dem leitfähigen Material 9 um Polysilizium. Sowohl das leitfähige Material 9 als auch die erste Zone 6 in dem ersten Graben 7 sind hoch dotiert, d.h. p⁺- bzw. n⁺-dotiert. Die Speicherkapazität wird also durch die p⁺-Zone und das n⁺-dotierte leitfähige Material gebildet. Das Herstellen des Kondensators wird im folgenden als Schritt a) bezeichnet.

Nachdem in Schritt a) der Kondensator in der ersten Zone 6 erzeugt worden ist, wird in Schritt b) eine zweite Zone 10 auf der ersten Zone 6 angeordnet, so daß der erste Graben 7 in der ersten Zone 6 abgedeckt ist. Vorzugsweise erfolgt dieses Anordnen der zweiten Zone 10 auf der ersten Zone 6 mittels dem Fachmann allgemein bekannten Techniken wie "Direct Wafer Bonding" oder "Smart Cut". Mit dem "Direct Wafer Bonding"- oder "Smart Cut"-Verfahren läßt sich auf einfache Art und Weise eine scharf definierte Grenzfläche 11 zwischen der ersten Zone 6 und der zweiten Zone 10 erzeugen.

Um die zweite Zone 10 auf eine Dicke zu bringen, die für die vertikale Ausdehnung des Auswahltransistors geeignet ist, wird die zweite Zone 10 nach dem Anordnen auf der ersten Zone bis auf eine Restschicht abgetragen, so daß sie anschließend eine vorgegebene Dicke hat.

Die zweite Zone 10 ist wie die erste Zone von dem ersten Leitfähigkeitstyp, jedoch ist sie aus Gründen, die weiter unten deutlich werden, schwächer dotiert als die erste Zone 6.

In Schritt c) wird in der zweiten Zone 10 ein "Bubble-" Bereich 12 erzeugt. Dazu wird die Umgebungstemperatur erhöht, so daß Dotierstoff aus dem leitfähigem Material 9 in dem ersten Graben 7 über die Grenzfläche 11 in die zweite Zone 10 diffundiert. Der Bubble-Bereich 12 bildet sich somit direkt oberhalb des Grabens 7 in der ersten Zone 6. Die Leitfähigkeit dieses Bubble-Bereichs 12 ist dieselbe wie die von dem leitfähigen Material 9 in dem Graben 7, d.h. n oder n⁺.

Nachdem in den bisherigen Schritten a) bis c) der "untere" Teil der DRAM-Zelle, d.h. die Speicherkapazität fertiggestellt wurde, wird in den folgenden Schritten die Zelle von ihren (nicht dargestellten) Nachbarzellen isoliert und der Auswahltransistor erzeugt. In Schritt d) werden Nachbarbereiche neben dem ersten Graben 7 geätzt. Beim Ätzen wird das Halbleitermaterial ausgehend von der Oberfläche bis in die erste Zone 6 hinein, d.h. über die Grenzfläche 11 hinaus entfernt.. Unter "Nachbarbereich neben dem ersten Graben" wird der Bereich verstanden, der sich wie in Fig. 1 ersichtlich seitlich oberhalb bzw. neben dem Graben in der ersten Zone 6 befindet. Die frei geräumten Nachbarbereiche werden in Schritt e) mit einem Isolatormaterial 13 wieder aufgefüllt, so daß sich eine im wesentlichen ebene Oberfläche ergibt. Durch das Isoliermaterial 13 wird ein Isolatorbereich zwischen benachbarten Gräben erzeugt. Die Nachbarbereiche des ersten Grabens 7 werden durch ein Dickoxyd oder einen anderen Isolator aufgefüllt. Die Dicke des Isolators beträgt dabei vorzugsweise mehr als 1 µm. Die Bitleitungs-Kapazität wird dadurch sehr klein. Nach dem Auffüllen der Nachbarbereiche wird die Oberfläche der DRAM- Zelle, d.h. die Oberfläche des restlichen Halbleiters über dem (vergrabenen) Graben 7 und des Isolatormaterials 13 planarisiert.

Auf der planarisierten Oberfläche werden in Schritt f) Bitleitungen 21 erzeugt. Die Bitleitungen 21 werden aus leitfähigem Material wie Polysilizium gebildet und sind von dem zweiten Leitfähigkeitstyp. Im Anschluß an die Bitleitungen 21 werden Drain-Zonen 18 für den Auswahltransistor 3 gebildet, vorzugsweise durch Diffusion von Dotierstoff aus dem leitfähigen Material 21 für die Bitleitung 1. Der Auswahltransistor selbst wird in Schritt g) in einer "Si-Säule" hergestellt. Dazu wird ein zweiter Graben 14 in der zweiten Zone 10 oberhalb des ersten Grabens 7 in der ersten Zone 6 erzeugt. Der zweite Graben 14 wird auf eine ähnliche Weise wie der erste Graben 7 hergestellt und mit einer Gate-Isolatorschicht 15 sowie einem Gate-Material 16 gefüllt, so daß ein Gate 17 des Auswahltransistors entsteht. Das Gate-Material 16 ist vorzugsweise wie das leitfähige Material 9 im ersten Graben 7 Polysilizium, das in der gezeigten Ausführungsform n- oder n⁺-dotiert ist. Zur Erläuterung ist der Auswahltransistor 3 schematisch in Fig. 1 eingezeichnet.

Mit Schritt g) ist ein Auswahltransistor fertiggestellt, dessen Drain 18 mit dem leitfähigen Material 21 der Bitleitung 1 zusammenhängt, dessen Source 19 der durch Diffusion entstandene n⁺-dotierte Bubble-Bereich 12 ist und dessen Gate 17 den Ladungsträgertransport durch einen Kanal 20 des Auswahltransistors steuert. Zur fehlerfreien Funktion des Auswahltransistors muß sichergestellt sein, daß die Kapazität des np-Übergangs bei der Source 19 kleiner bleibt als die Kapazität des Speicherkondensators 4, die durch das leitfähige Material 9 in dem ersten Graben 7 und der ersten Zone 6 gebildet wird. Dies wird durch die unterschiedliche Dotierung der ersten Zone 6 und der zweiten Zone 10 erreicht. Damit ergibt sich als weiterer Vorteil des Verfahrens, bei dem Speicherkondensator und Auswahltransistor "getrennt" voneinander hergestellt werden und durch Wafer Bonding miteinander verbunden werden, daß ein sehr abrupter Übergang im Dotierungsprofil zwischen erster Zone 6 und zweiter Zone 10 einfach zu bewerkstelligen ist.

Fertiggestellt wird die DRAM-Zelle in Schritt h), bei dem leitfähiges Material 22 für die Wortleitungen 2 auf der freiliegenden Oberfläche der zweiten Zone 10 abgeschieden wird. Dieses Material ist ebenfalls wie bei den Bitleitungen vorzugsweise Polysilizium, Al oder W.

Bei den obigen Verfahrensschritten erfolgt das Beschichten mit einer Isolatorschicht 8 bzw. 15 vorzugsweise durch Oxidieren des Halbleitermaterials. Damit läßt sich das Verfahren weiter vereinfachen.

Zusammenfassend sind die wesentlichen Merkmale des erfindungsgemäßen Verfahrens bei der gezeigten Ausführungsform somit, daß der Speicherkondensator in einer p⁺-Zone als Graben-(Trench-) Kapazität mit Gateoxyd und n⁺- Polysilizium ausgeführt wird. Der Auswahltransistor befindet sich in einer Si-Säule. Diese Säule ist teilweise p⁺- und teilweise p-dotiert. Die p⁻/p⁺-Zonen werden mit "Direct Wafer Bonding" oder mit "Smart Cut" zueinander gebondet, nachdem der Graben (Trench) für den Speicherkondensator mit isolierter Polysiliziumfüllung hergestellt wurde. Aus dem n⁺-Polysilizium wird durch Diffusion der n⁺- Bubble-Bereich erzeugt. Danach werden die Siliziumsäulen tief in die p⁺-Zone geätzt, die Zwischenräume mit Isolator gefüllt, und danach wird mit gängiger Methode die Scheibe planarisiert. Nachdem die Bitleitungen aus n⁺⁻Polysilizium erzeugt wurden und die n⁺-dotierten Drain-Zonen für die Auswahltransistoren vorbereitet sind, erfolgt das Trench-Ätzen, Oxydieren und Auffüllen für den Auswahltransistor mit vertikalem Kanal. Seine isolierte Gatefüllung (z.B. n⁺-Polysilizium mit Metalloberfläche) dient gleichzeitig als Wortleitung.

Die gesamte Fläche der mit dem erfindungsgemäßen Verfahren hergestellten DRAM-Zelle ist kaum größer als die Kreuzfläche der Bit- und Wort-Leitungen. Ferner sind für die Zellenherstellung nach dem obigen Verfahren nur etwa 5 Masken notwendig.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Insbesondere müssen die beiden Gräben nicht genau vertikal übereinander orientiert sein, sondern können zueinander versetzt sein, solange der Bubblebereich die Gateisolationsschicht des oberen Grabens erreicht.

## Patentansprüche

1. Verfahren zum Herstellen einer DRAM-Speicherzelle mit einem Grabenkondensator, das die Schritte umfaßt:
Erzeugen eines ersten Grabens (7) in einer ersten Zone (6) von einem ersten Leitfähigkeitstyp, Beschichten der Oberfläche des ersten Grabens (7) mit einer ersten Isolatorschicht (8) und Auffüllen des ersten Grabens (7) mit einem leitfähigen Material (9) von einem zweiten Leitfähigkeitstyp, wobei die erste Zone und das leitfähige Material hoch dotiert sind; Anordnen einer zweiten Zone (10) von dem ersten Leitfähigkeitstyp auf der ersten Zone, so daß der erste Graben (7) abgedeckt ist;
Erzeugen eines Bereiches (12) von dem zweiten Leitfähigkeitstyp in der zweiten Zone (10) durch Diffusion von Dotierstoff aus dem leitfähigem Material (9) in dem ersten Graben (7);
Ätzen von Nachbarbereichen neben dem ersten Graben (7), so daß Halbleitermaterial ausgehend von der Oberfläche der zweiten Zone (10) bis in die erste Zone (6) hinein entfernt wird;
Auffüllen der Nachbarbereiche mit einem Isolatormaterial (13), so daß ein Isolatorbereich zwischen benachbarten Gräben erzeugt wird;
Erzeugen von Bitleitungen (1) aus leitfähigem Material (21) von dem zweiten Leitfähigkeitstyp und von Drain-Zonen (18) für Auswahltransistoren an der Oberfläche der zweiten Zone (10);
Erzeugen des Auswahltransistorgates (3) in einem zweiten Graben (14) in der zweiten Zone (10) oberhalb des ersten Grabens (7) in der ersten Zone (6); und
Erzeugen von Wortleitungen (2) aus leitfähigem Material (22) auf der freiliegenden Oberfläche der zweiten Zone (10).

2. Verfahren nach Anspruch 1, **dadurch gekennzeichnet, daß** das Anordnen der zweiten Zone (10) auf der ersten Zone (6) die Schritte "Direct Wafer Bonding" der zweiten Zone (10) auf der ersten Zone (6) und Dünnen der zweiten Zone (10) auf eine vorgegebene Dicke umfaßt.

3. Verfahren nach Anspruch 1 oder 2, **dadurch gekennzeichnet, daß** das Beschichten mit einer Isolatorschicht durch Oxidieren des Halbleitermaterials erfolgt.

4. Verfahren nach einem der Ansprüche 1 bis 3, **dadurch gekennzeichnet, daß** die Nachbarbereiche des ersten Grabens (7) durch ein Dickoxyd aufgefüllt werden.

5. Verfahren nach einem der Ansprüche 1 bis 4, **dadurch gekennzeichnet, daß** das Isolatormaterial aus mehreren Schichten besteht.

## Claims

1. Method for fabricating a DRAM memory cell having a trench capacitor, which comprises the steps of:
producing a first trench (7) in a first zone (6) of a first conductivity type, coating the surface of the first trench (7) with a first insulator layer (8) and filling the first trench (7) with a conductive material (9) of a second conductivity type, the first zone and the conductive material being highly doped;
arranging a second zone (10) of the first conductivity type on the first zone, so that the first trench (7) is covered;
producing a region (12) of the second conductivity type in the second zone (10) by diffusion of dopant from the conductive material (9) in the first trench (7);
etching adjacent regions next to the first trench (7), so that semiconductor material is removed proceeding from the surface of the second zone (10) right into the first zone (6);
filling the adjacent regions with an insulator material (13), so that an insulator region is produced between adjacent trenches;
producing bit lines (1) made of conductive material (21) of the second conductivity type and drain zones (18) for selection transistors on the surface of the second zone (10);
producing the selection transistor gate (3) in a second trench (14) in the second zone (10) above the first trench (7) in the first zone (6); and
producing word lines (2) made of conductive material (22) on the uncovered surface of the second zone (10).

2. Method according to Claim 1, **characterized in that** arranging the second zone (10) on the first zone (6) comprises the steps of "Direct Wafer Bonding" of the second zone (10) on the first zone (6) and thinning of the second zone (10) to a predetermined thickness.

3. Method according to Claim 1 or 2, **characterized in that** the process of coating with an insulator layer is effected by oxidation of the semiconductor material.

4. Method according to one of Claims 1 to 3, **characterized in that** the adjacent regions of the first trench (7) are filled by a thick oxide.

5. Method according to one of Claims 1 to 4, **characterized in that** the insulator material comprises a plurality of layers.

## Revendications

1. Procédé de production d'une cellule de mémoire DRAM avec un condensateur de tranchée, ledit procédé comprenant les étapes suivantes :
- générer une première tranchée (7) dans une première zone (6) d'un premier type de conductivité, revêtir la surface de la première tranchée (7) avec une première couche isolante (8) et remplir la première tranchée (7) d'un matériau conducteur (9) d'un second type de conductivité, la première zone et le matériau conducteur étant très dopés ;
- disposer une seconde zone (10) du premier type de conductivité sur la première zone de manière à recouvrir la première tranchée (7) ;
- générer une zone (12) du second type de conductivité dans la seconde zone (10) par diffusion de dope depuis le matériau conducteur (9) dans la première tranchée (7) ;
- graver les zones voisines situées à côté de la première tranchée (7) en vue d'éliminer le matériau semi-conducteur depuis la surface de la seconde zone (10) jusque dans la première zone (6) ;
- remplir les zones voisines d'un matériau isolant (13) pour générer une zone isolante entre les tranchées voisines ;
- générer des lignes de bits (1) constituées de matériau conducteur (21) du second type de conductivité, et des zones de drain (18) pour des transistors de sélection à la surface de la seconde zone (10) ;
- générer la porte du transistor de sélection (3) dans une seconde tranchée (14) située dans la seconde zone (10) au-dessus de la première tranchée (7) dans la première zone (6) ; et
- générer des lignes de mots (2) constituées de matériau conducteur (22) sur la surface dégagée de la seconde zone (10).

2. Procédé selon la revendication 1, **caractérisé en ce que** la disposition de la seconde zone (10) sur la première zone (6) comprend les étapes « Direct Wafer Bonding » de la seconde zone (10) sur la première zone (6) et l'amincissement de la seconde zone (10) à une épaisseur prédéfinie.

3. Procédé selon la revendication 1 ou 2, **caractérisé en ce que** le revêtement avec une couche isolante s'opère par oxydation du matériau semi-conducteur.

4. Procédé selon l'une quelconque des revendications 1 à 3, **caractérisé en ce que** les zones voisines de la première tranchée (7) sont remplies d'un oxyde épais.

5. Procédé selon l'une quelconque des revendications 1 à 4, **caractérisé en ce que** le matériau isolant se compose de plusieurs couches.
